# DEMANDE DE BREVET EUROPEEN

(11) **EP 2 284 894 A1**
(43) Date de publication de la demande: **16.02.2011**
(21) Numéro de dépôt: 10171733.8
(22) Date de dépôt: 03.08.2010
(51) Int. Cl.: H01L 27/146

(54) **Capteur d'images éclairé par la face arrière protégé des rayons infrarouges**

(30) Priorité: 12.08.2009 FR 0955635
(71) Demandeur: STmicroelectronics SA, 92120 Montrouge (FR)
(72) Inventeur: Wehbe-Alause, Hélène, 38660, LE TOUVET (FR)
(74) Mandataire: de Beaumont, Michel

(57) **Abrégé**

L'invention concerne un capteur d'images comprenant un premier substrat (40) ayant une première face destinée à être éclairée (64) et une seconde face du côté de laquelle est formée une pluralité de zones de photodétection (42), la seconde face étant recouverte d'un empilement de niveaux d'interconnexion comprenant des pistes métalliques surmontées de matériau isolant, et d'un second substrat (56) reporté sur le matériau isolant du dernier niveau d'interconnexion, dans lequel sont formés des vias traversants (66) en contact avec des éléments de connexion des niveaux d'interconnexion, au moins un niveau d'interconnexion comportant des zones conductrices de blindage (54) en regard des zones de photodétection.

## Description

### Domaine de l'invention

La présente invention concerne un capteur d'images éclairé par la face arrière et, plus particulièrement, un capteur d'images éclairé par la face arrière comprenant des éléments permettant d'éviter la détection de rayons infrarouges parasites.

### Exposé de l'art antérieur

Un souci permanent dans la fabrication de capteurs d'images formés sur des substrats semiconducteurs est d'éviter la détection de faisceaux lumineux parasites. Notamment, quand on cherche à réaliser un capteur d'images couleur dans le domaine du visible sensible aux mêmes rayonnements que l'oeil humain, on cherche à éviter l'influence des rayons infrarouges.

Il est donc nécessaire de prévoir des éléments pour éviter la détection des faisceaux lumineux infrarouges. Pour cela, du côté du capteur destiné à recevoir un éclairement, on prévoit généralement des éléments, par exemple une plaque de résine qui filtre les rayons infrarouges.

Du côté de la structure non éclairée, des dispositifs formant contact avec des éléments de photodétection, par exemple des billes de soudure, sont généralement prévus. Ainsi, le dispositif se trouve légèrement éloigné du support sur lequel il sera fixé par la suite. Des rayons infrarouges parasites peuvent pénétrer par la face non éclairée jusqu'à atteindre le substrat semiconducteur. En effet, dans des matériaux semiconducteurs, et notamment dans le silicium, des rayons infrarouges incidents provoquent la formation de paires électrons/trous profondément dans le silicium. Ainsi, des faisceaux infrarouges peuvent être détectés dans des zones de photodétection éloignées du point de pénétration du faisceau dans le substrat. Pour éviter une détection parasite de ces rayons, une technique classique consiste à former, du côté non éclairé, une couche de résine noire bloquant ces rayons et tout autre rayon lumineux.

Pour former une telle structure, on dépose une couche de résine noire sur l'ensemble de la face à protéger puis on définit des ouvertures dans cette couche de résine. Des billes de soudure sont ensuite formées dans ces ouvertures. Ainsi, l'obtention d'une couche de résine noire implique la réalisation d'étapes de fabrication supplémentaires par rapport aux procédés classiques déjà très complexes de formation de capteurs d'images. Une des limitations de cette couche de résine réside dans ses variations d'épaisseur au passage des routages de connexions de face arrière, faisant ainsi fluctuer localement son efficacité. Une autre interaction négative se produit avec des plots métalliques d'accrochage qui sont généralement prévus, avant la formation des billes de soudure : cette résine noire doit être dégagée au dessus des plots d'accrochage pour permettre la formation d'un composé intermétallique entre le plot et la bille. Cependant, tous les résidus de résine à ces endroits tendront à limiter la formation de composés intermétalliques dégradant ainsi à la fois le contact électrique et la tenue mécanique du boîtier lorsqu'il est uniquement maintenu par ces billes.

De plus, une résine noire coûte relativement cher si elle est formée sur une surface importante, à savoir sur la totalité d'une tranche de matériau semiconducteur. Ces résines présentent également l'inconvénient d'être relativement fragiles. Ainsi, lors des étapes de montage du capteur d'images, des rayures ou des fissures de cette résine peuvent être provoquées, ce qui en annule l'intérêt et provoque en face avant de ces défauts des images parasites ponctuelles.

Ainsi, un besoin existe d'un capteur d'images comprenant des éléments, autres qu'une couche de résine noire, permettant d'atténuer la détection de faisceaux lumineux infrarouges parasites.

### Résumé

Un objet d'un mode de réalisation de la présente invention est de prévoir un capteur d'images éclairé par la face arrière comprenant des éléments permettant d'éviter la détection de faisceaux lumineux infrarouges parasites.

Un autre objet d'un mode de réalisation de la présente invention est de prévoir un procédé de fabrication d'un tel capteur d'images ne nécessitant pas d'étapes supplémentaires par rapport aux procédés de fabrication classiques.

Un mode de réalisation de la présente invention prévoit un capteur d'images comprenant un premier substrat ayant une première face destinée à être éclairée et une seconde face du côté de laquelle est formée une pluralité de zones de photodétection, la seconde face étant recouverte d'un empilement de niveaux d'interconnexion comprenant des pistes métalliques surmontées de matériau isolant, et d'un second substrat reporté sur le matériau isolant du dernier niveau d'interconnexion dans lequel sont formés des vias traversants en contact avec des éléments de connexion des niveaux d'interconnexion, au moins un niveau d'interconnexion comportant des zones conductrices de blindage en regard des zones de photodétection.

Selon un mode de réalisation de la présente invention, les zones conductrices de blindage comprennent une piste conductrice étendue formée en regard des zones de photodétection dans un niveau d'interconnexion.

Selon un mode de réalisation de la présente invention, les zones conductrices de blindage comprennent un premier ensemble de pistes conductrices parallèles formées dans un premier niveau d'interconnexion et un second ensemble de pistes conductrices parallèles formées dans un second niveau d'interconnexion, les pistes conductrices des premier et second ensembles étant perpendiculaires entre elles.

Selon un mode de réalisation de la présente invention, le capteur d'images comprend en outre, du côté libre du second substrat et sur les vias traversants, des billes de soudure.

Selon un mode de réalisation de la présente invention, le capteur d'images comprend en outre une plaque de verre formée sur la première face du premier substrat.

Selon un mode de réalisation de la présente invention, les premier et second substrats sont en silicium et présentent une épaisseur comprise entre 60 et 80 µm.

Un mode de réalisation de la présente invention prévoit un procédé de formation d'un capteur d'images éclairé par la face arrière, comprenant les étapes consistant à former, dans et sur un premier substrat semiconducteur, des éléments de photodétection surmontés de niveaux d'interconnexion comprenant chacun des pistes métalliques surmontées d'un matériau isolant ; former, dans au moins un niveau d'interconnexion, des zones conductrices de blindage en regard de zones de photodétection des éléments de photodétection ; reporter un second substrat semiconducteur sur le matériau isolant du dernier niveau d'interconnexion et amincir le premier substrat ; reporter une plaque de verre du côté de la face du premier substrat aminci opposée au dernier niveau d'interconnexion et amincir le second substrat ; et former des vias traversants dans le second substrat.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1E illustrent des résultats d'étapes d'un procédé de formation d'un capteur d'images selon un mode de réalisation de la présente invention ;
la figure 2 est un schéma tridimensionnel simplifié illustrant un premier exemple de capteur d'images selon un mode de réalisation de la présente invention ; et
la figure 3 est une vue en perspective simplifiée d'un second exemple de capteur d'images selon un mode de réalisation de la présente invention.

Par souci de clarté, de mêmes éléments ont été désignés par de mêmes références aux différentes figures et, de plus, comme cela est habituel dans la représentation des capteurs d'images, les diverses figures ne sont pas tracées à l'échelle.

### Description détaillée

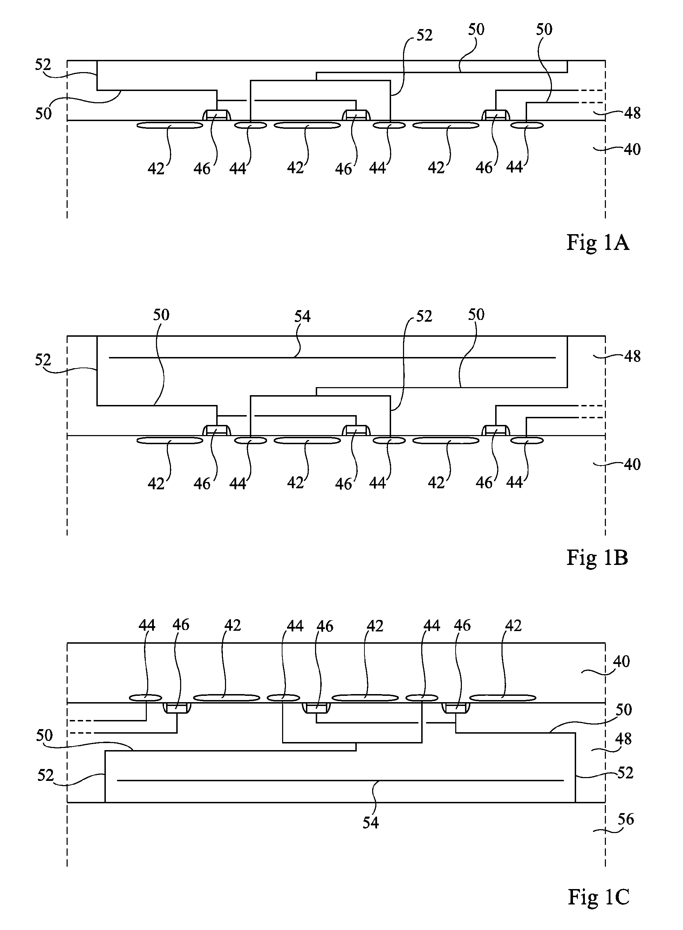

Les figures 1A à 1E illustrent des résultats d'étapes d'un procédé de fabrication d'un capteur d'images éclairé par la face arrière.

A l'étape illustrée en figure 1A, on a formé, dans et sur un substrat semiconducteur 40, par exemple de silicium, des éléments de photodétection d'images, par exemple des zones de photodétection 42 et des zones de transfert des charges photo-générées 44 et des transistors de transfert et de lecture de charges 46. On notera que d'autres éléments peuvent être formés dans et sur le substrat 40.

Sur l'ensemble de la structure est formé un empilement d'interconnexion 48 dans lequel sont formées des pistes 50 et des vias 52 permettant de connecter les différents éléments de photodétection entre eux et vers l'extérieur du dispositif. Chaque niveau d'interconnexion est recouvert d'une couche de matériau isolant permettant d'éviter la formation de court-circuit dans l'empilement d'interconnexion. Des contacts vers l'extérieur du dispositif sont prévus sur la face supérieure de l'empilement d'interconnexion 48. On notera que, de façon classique, les contacts vers l'extérieur du dispositif sont excentrés des zones de photodétection.

A l'étape illustrée en figure 1B, l'empilement d'interconnexion 48 a été complété de niveaux supérieurs. Dans un ou plusieurs niveaux d'interconnexion supérieurs de l'empilement d'interconnexion 48 est formée une zone conductrice 54 recouvrant sensiblement l'ensemble de la zone de photodétection.

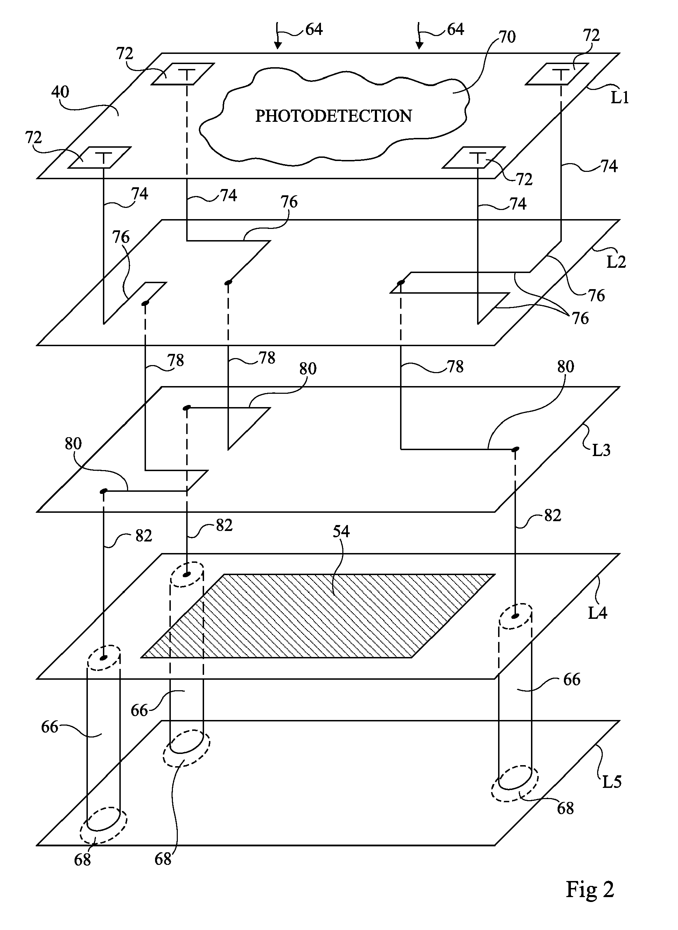

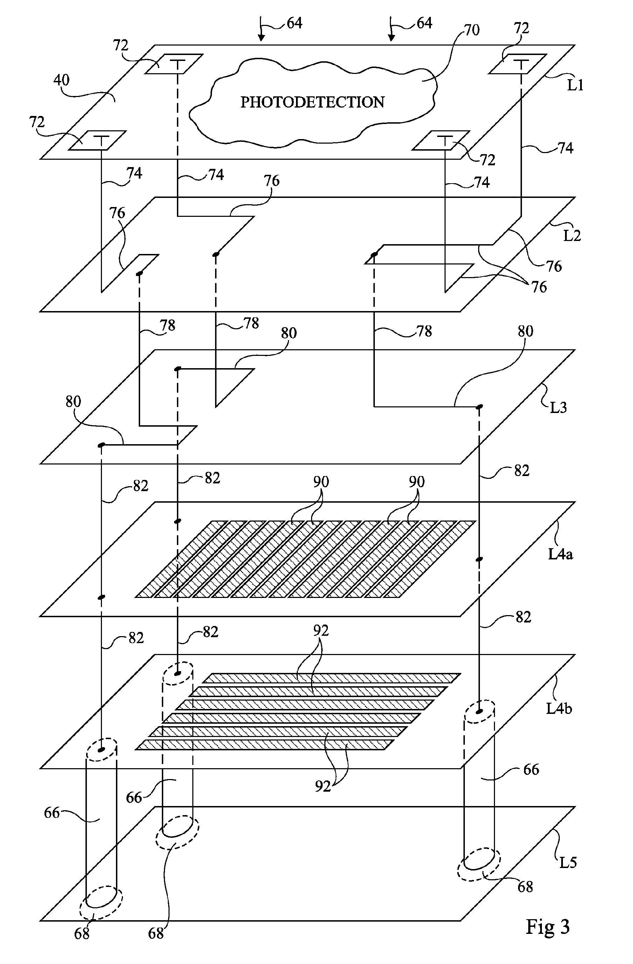

En figure 1B et dans les figures 1C à 1E, on a représenté une unique zone 54 s'étendant sur la totalité de la surface en regard de la zone de photodétection. Comme nous le verrons par la suite en relation avec les figures 2 et 3, diverses structures constituant la zone 54 sont possibles. De plus, la zone 54 peut également être prévue dans n'importe quel niveau d'interconnexion, et notamment dans un des premiers niveaux d'interconnexion.

La zone conductrice 54 a pour rôle de bloquer des rayons infrarouges arrivant par la face avant du dispositif, assurant ainsi une fonction de blindage comme nous le verrons ci-après. Avantageusement, la formation de la zone conductrice 54 n'implique pas d'étapes supplémentaires par rapport à des procédés classiques de fabrication de capteurs d'images éclairés par la face arrière puisque, dans ces procédés, des pistes sont formées dans les différents niveaux d'interconnexion, notamment pour connecter des éléments de traitement d'image disposés en périphérie de la zone de photodétection. Ainsi, l'ajout de la région conductrice 54 implique seulement une modification du ou des masques utilisés dans la fabrication d'un ou de plusieurs niveaux d'interconnexion.

A l'étape illustrée en figure 1C, on a formé un substrat semiconducteur 56, par exemple en silicium, sur l'empilement d'interconnexion 48. Le dispositif est ensuite retourné et le substrat 40 est aminci pour présenter une épaisseur comprise entre 60 et 80 µm, par exemple d'environ 70 µm avec les technologies courantes, mais éventuellement moins.

On notera que les étapes de report d'un substrat semiconducteur sur le matériau isolant recouvrant le dernier niveau de l'empilement d'interconnexion, et d'amincissement d'un substrat semiconducteur, sont des étapes classiques des procédés de formation de capteurs d'images éclairés par la face arrière. Ainsi, ces étapes ne seront pas décrites ici plus en détail. On notera également que les techniques de report de substrats semiconducteurs sur des couches isolantes (par l'intermédiaire par exemple d'une fine couche isolante formée sur le substrat) sont de bien meilleure qualité que les techniques de report dans lesquelles le substrat semiconducteur est fixé sur le dispositif par l'intermédiaire de couches métalliques.

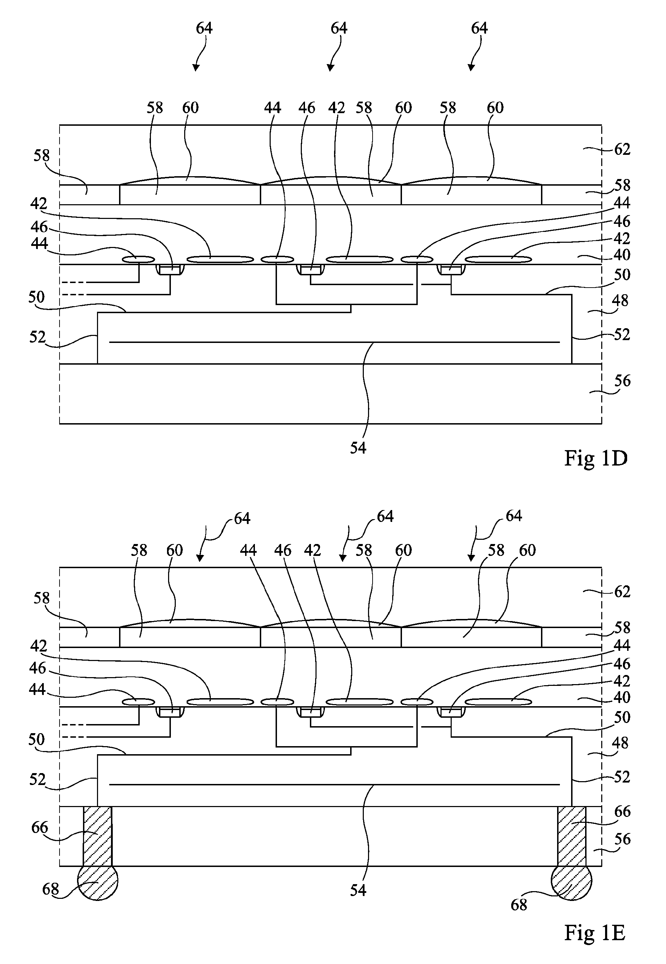

A l'étape illustrée en figure 1D et dans le cas d'un capteur d'images couleur, on a formé, sur le substrat 40, des filtres colorés 58. Des microlentilles 60 sont ensuite formées sur les filtres colorés. Sur le dessus de l'empilement des filtres colorés 58 et des microlentilles 60 est accolée une plaque épaisse de verre 62. La plaque de verre 62 permet de rigidifier le dispositif tout en étant transparente pour des rayons lumineux visibles arrivant par la face arrière du dispositif (flèche 64) et en bloquant tout rayonnement infrarouge.

Le deuxième substrat 56 est ensuite aminci pour présenter une épaisseur comprise de préférence entre 60 et 80 µm, par exemple de 70 µm. Cette épaisseur est prévue de façon à permettre une formation simple de vias traversant le substrat 56 (TSV).

A l'étape illustrée en figure 1E, on a formé des vias 66 au travers du substrat 56. Les vias 66 sont prévus pour connecter des vias 52 de l'empilement d'interconnexion 48 vers l'extérieur du dispositif. Ensuite, des billes de soudure 68 sont formées sur la face avant du dispositif pour permettre son montage, par exemple sur une plaque de circuit imprimé.

Ainsi, avantageusement, on obtient un dispositif dans lequel des faisceaux lumineux infrarouges parasites arrivant par la face avant (face inférieure en figure 1E) du dispositif sont stoppés par la zone conductrice 54 formée dans l'empilement d'interconnexion 48, zone encore appelée par la suite zone de blindage. De plus, le procédé présenté ici a l'avantage de ne pas nécessiter d'étapes supplémentaires par rapport à un procédé classique de formation d'un capteur d'images éclairé par la face arrière, puisqu'on a généralement besoin de plus de niveaux d'interconnections dans la partie logique que dans la zone de la matrice de pixels et que certains de ces niveaux sont donc inutilisés dans la partie optique du dispositif.

Plusieurs solutions sont possibles pour former la zone de blindage 54. Les figures 2 et 3 sont des vues en perspectives très schématiques illustrant les deux exemples de formation de la zone conductrice de blindage 54. Les figures 2 et 3 représentent des niveaux, parallèles entre eux, s'étendant dans le dispositif.

Dans la représentation schématique de la figure 2, un premier niveau L1 comprend l'ensemble des éléments de photodétection du dispositif et correspond sensiblement au substrat semiconducteur 40. Ce niveau comprend une zone de photodétection 70 destinée à recevoir des faisceaux lumineux 64 et des zones de transfert 72, par exemple des transistors T.

Dans l'exemple représenté, deux niveaux L2 et L3 d'interconnexion sont destinés à recevoir des pistes d'interconnexion des éléments de détection d'images. Des vias 74 sont formés entre les niveaux L1 et L2, des pistes 76 sont formées sur le niveau L2, des vias 78 sont formés entre le niveau L2 et L3 et des pistes 80 sont formées sur le niveau L3. Deux ou trois niveaux suffisent généralement pour former les interconnexions entre les divers éléments de photodétection. Ainsi, les derniers niveaux d'interconnexion ne sont pas utilisés pour connecter ensemble des éléments de photodétection et ces derniers niveaux sont traversés par des vias 82 verticaux jusqu'au dernier niveau d'interconnexion.

Dans l'exemple de la figure 2, sur un niveau L4 constituant par exemple l'un des derniers niveaux d'interconnexion de l'empilement d'interconnexion, une zone conductrice 54, par exemple en cuivre, est formée en regard de la zone de photodétection 70 du niveau L1. Dans le cas de la figure 2, une unique plaque conductrice en regard de l'ensemble de la surface de photodétection forme le blindage aux rayons infrarouges. Avantageusement, la formation des zones de blindage seulement en regard des zones de photodétection, et non pas sur la totalité de la surface disponible dans le niveau L4, permet d'éviter des phénomènes de courbure du dispositif qui pourraient découler de la formation de portions conductrices de grandes dimensions. De plus, la formation des zones de blindage est avantageusement réalisée simultanément avec les lignes métalliques présentes sur le même niveau, par exemple par dépôt de matériau conducteur puis polissage mécano-chimique.

Un dernier niveau d'interconnexion L5 de la structure porte les billes de soudure 68. Des vias 66 traversant le substrat sont formés entre les niveaux L4 et L5 (dans le substrat 56 des figures précédentes).

Dans la variante de la figure 3, les trois premiers niveaux de la structure L1 à L3 sont identiques à ceux de la figure 2. Le niveau L4 est remplacé par deux niveaux d'interconnexion L4a et L4b qui sont traversés par des vias verticaux 82 de connexion des éléments de photodétection à l'extérieur du dispositif. En regard de la zone de photodétection 70 du niveau L1, sur le niveau L4a, sont formés des pistes conductrices 90 s'étendant parallèlement les unes aux autres. Les pistes 90 s'étendent sur toute la surface en regard de la zone de photodétection et recouvrent une grande partie de cette surface (la largeur des pistes 90 est de préférence supérieure à l'espace entre chacune des ces pistes).

Sur le niveau L4b sont formées des pistes 92 parallèles entre elles s'étendant en regard de la zone de photodétection 70, mais perpendiculaires aux pistes conductrices 90 du niveau L4a. A titre d'exemple, les pistes 90 et 92 peuvent être en cuivre ou en tout matériau utilisé classiquement pour former des pistes conductrices d'interconnexion, par exemple en aluminium ou en tungstène.

Ainsi, des faisceaux lumineux infrarouges arrivant par la face inférieure du dispositif (du côté du niveau L5) sont bloqués soit par les pistes conductrices 92, soit par les pistes conductrices 90. On notera que les dimensions des pistes 90 et 92 seront définies aisément par l'homme de l'art de façon à bloquer efficacement ces faisceaux lumineux.

On notera que la variante de la figure 3 présente l'avantage de ne former que des pistes conductrices classiques (largeur similaire à celle des pistes d'interconnexion) dans les niveaux L4a et L4b. En effet, bien que cela soit possible, il est plus difficile de déposer une surface conductrice 54 étendue, comme dans le cas de la figure 2, que des pistes telles que les pistes 90 et 92, le dépôt d'une couche conductrice 54 étendue pouvant impliquer des étapes de planarisation complexes.

Des modes de réalisation particuliers de la présente invention ont été décrits. Diverses variantes et modifications apparaîtront à l'homme de l'art. En particulier, on notera que la forme de la zone conductrice de blindage représentée en figures 2 et 3 n'est pas limitative. En effet, on pourra prévoir d'autres formes de pistes conductrices 90 et 92 dans deux niveaux d'interconnexion ou dans plus de deux niveaux d'interconnexion pour former le blindage aux rayons infrarouges. On pourra notamment prévoir de former des pistes conductrices dans trois ou quatre niveaux d'interconnexion selon des motifs particuliers, par exemple entrecroisés, en regard de la zone de photodétection 70.

On pourra également prévoir de former les zones de blindage au plus près des zones de photodétection, à savoir dans les premiers niveaux d'interconnexion, si cela est possible, par exemple si les interconnexions entre les différents éléments des zones de photodétection ne nécessitent que peu de niveaux d'interconnexion. La formation des zones de blindage au plus près des zones de photodétection permet de bloquer tout rayon parasite voyageant par la face avant du dispositif.

## Revendications

1. Capteur d'images comprenant un premier substrat (40) ayant une première face destinée à être éclairée (64) et une seconde face du côté de laquelle est formée une pluralité de zones de photodétection (42, 70), ladite seconde face étant recouverte d'un empilement de niveaux d'interconnexion comprenant des pistes métalliques surmontées de matériau isolant, et d'un second substrat (56) reporté sur le matériau isolant du dernier niveau d'interconnexion dans lequel sont formés des vias traversants (66) en contact avec des éléments de connexion des niveaux d'interconnexion, au moins un niveau d'interconnexion comportant des zones conductrices de blindage (54) en regard des zones de photodétection.

2. Capteur d'images selon la revendication 1, dans lequel les zones conductrices de blindage comprennent une piste conductrice étendue (54) formée en regard des zones de photodétection (42, 70) dans un niveau d'interconnexion.

3. Capteur d'images selon la revendication 1, dans lequel les zones conductrices de blindage comprennent un premier ensemble de pistes conductrices parallèles (90) formées dans un premier niveau d'interconnexion et un second ensemble de pistes conductrices parallèles (92) formées dans un second niveau d'interconnexion, les pistes conductrices des premier et second ensembles étant perpendiculaires entre elles.

4. Capteur d'images selon l'une quelconque des revendications 1 à 3, comprenant en outre, du côté libre du second substrat (56) et sur les vias traversants (66), des billes de soudure (68).

5. Capteur d'images selon l'une quelconque des revendications 1 à 4, comprenant en outre une plaque de verre (62) formée sur la première face du premier substrat (40).

6. Capteur d'images selon la revendication 5, dans lequel les premier et second substrats sont en silicium et présentent une épaisseur comprise entre 60 et 80 µm.

7. Procédé de formation d'un capteur d'images éclairé par la face arrière, comprenant les étapes suivantes :
former, dans et sur un premier substrat semiconducteur (40), des éléments de photodétection (42, 44, 46) surmontés de niveaux d'interconnexion comprenant chacun des pistes métalliques surmontées d'un matériau isolant ;
former, dans au moins un niveau d'interconnexion, des zones conductrices de blindage (54) en regard de zones de photodétection des éléments de photodétection ;
reporter un second substrat semiconducteur (56) sur le matériau isolant du dernier niveau d'interconnexion et amincir le premier substrat (40) ;
reporter une plaque de verre (62) du côté de la face du premier substrat aminci opposée au dernier niveau d'interconnexion et amincir le second substrat ; et
former des vias traversants (66) dans le second substrat.
